# EUROPEAN PATENT APPLICATION

(11) **EP 1 829 819 A2**
(43) Date of publication of application: **05.09.2007**
(21) Application number: 06125198.9
(22) Date of filing: 01.12.2006
(51) Int. Cl.: B81B 7/00

(54) **Passive thermal isolation structure**

(30) Priority: 03.03.2006 US 276538
(71) Applicant: Honeywell International Inc., Morristown, NJ 07962 (US)
(72) Inventor: Younger, Dan W., Maple Grove, MN 55311 (US); Lust, Lisa M, Plymouth, MN 55441 (US)
(74) Representative: Haley, Stephen

(57) **Abstract**

A thermal isolation structure for use in passively regulating the temperature of a microdevice is disclosed. The thermal isolation structure can include a substrate wafer and a cap wafer defining an interior cavity, and a number of double-ended or single-ended thermal bimorphs coupled to the substrate wafer and thermally actustable between an initial position and a deformed position. The thermal bimorphs can be configured to deform and make contact with the cap wafer at different temperatures, creating various thermal shorts depending on the temperature of the substrate wafer. When attached to a microdevice such as a MEMS device, the thermal isolation structure can be configured to maintain the attached device at a constant temperature or within a particular temperature range.

## Description

This invention was made with government support under DARPA contract number N66001-02-C-8019. The government may have certain rights in the invention.

The present invention relates generally to the field of temperature control in microdevices. More specifically, the present invention pertains to passive analog thermal isolation structures for use with microdevices such as MEMS devices.

Microelectromechanical systems (MEMS) are becoming increasingly popular as an alternative to conventional electromechanical devices such as inertial sensors, switches, relays, actuators, optical lenses, and valves. In the fabrication of inertial sensors for use in navigational and communications systems, for example, many of the sensor components such as gyroscopes and accelerometers are now being fabricated on etched wafers using batch semiconductor fabrication techniques. Because these MEMS devices can be fabricated on a smaller scale and with a higher degree of precision, such devices are often favored over more conventional electromechanical devices. In some applications, such MEMS devices can provide new functionality not capable with more conventional electromechanical devices.

In certain MEMS devices, it may be necessary to control the temperature on the package structure to maintain the device at a fixed operating temperature or within a pre-detemimed temperature range. In some MEMS-based inertial sensors, for example, it is sometimes necessary to maintain certain sensor components within the package at a constant temperature in a wide range of ambient temperature conditions. In some inertial sensors for use in navigational and communications systems, for example, ambient conditions of between -40°C to 80°C are not uncommon.

To maintain a fixed temperature on the package structure, many MEMS devices employ active heating elements to heat the structure. Typically, the heating elements are activated by passing a current through the element, causing heat to be transferred into the package structure. While effective in heating the MEMS package, such heating elements can consume significant amou8ts of power and can add to the complexity of the control electronics required to operate the MEMS device. Accordingly, there is a need for passive analog thermal isolation structures that can be used to passively regulate the temperature of microdevices such as MEMS devices.

The present invention pertains to passive analog thermal isolation structures for use with microdevices such as MEMS devices. A thermal isolation structure in accordance with an illustrative embodiment can include a substrate wafer and a cap wafer defining an interior cavity, and a number of thermal bimorphs each coupled to the substrate wafer and thermally actuatable between an initial position and a deformed position. Each of the thermal bimorphs can include either a double-ended structure having a first end, a second end, and a contact surface adapted to make thermal contact with the cap wafer, or a single-ended structure having a fixed end, a free end, and a contact surface near the free end adapted to make thermal contact with the cap wafer. The thermal bimorphs can be formed from two or more layers of material having different temperature conductivity coefficients, allowing the thermal bimorphs to deform in response to heat from the substrate wafer and/or the attached microdevice. In an alternative embodiment, the thermal actuation double-ended beam can be made substantially from a single material whose thermal expansion coefficient is different from the thermal expansion coefficient of the substrate. In this embodiment, when the substrate is heated, the double-ended thermal bimorph expands more than the substrate, resulting in an induced stress that causes the thermal bimorph to deform. In certain embodiments, a number of liquid metal contact regions can be farmec3 on the cap wafer to facilitate heat transfer from the thermal bimorphs to the cap wafer. The liquid metal contact regions can be deposited within several trenches formed on the cap wafer, and can be configured to wet with a layer of wettable material on the thermal bimorphs.

During use, the thermal bimorphs can be configured to deform and make contact with the cap wafer at different temperatures, forming a number of thermal shorts that transfer heat from the substrate wafer to the cap wafer. When attached to a microdevice such as MEMS device, the thermal isolation structure can be configured to maintain the attached device at a constant temperature and/or within a desired temperature range, In some applications, the thermal isolation structure can permit the microdevice to self-heat to a particular temperature without the use of active heating elements, reducing power consumption and decreasing the complexity of the control electronics required to operate the device.

In the Drawings;
Figure 1 is a schematic side cross-sectional view showing an illustrative passive analog thermal isolation structure in accordance with an illustrative embodiment of the present invention;
Figure 2 is a top schematic view showing an illustrative liquid metal contact region having a spiraled pattern;
Figure 3 is a top schematic view showing an illustrative liquid metal contact region having a star-shaped pattern;
Figure 4 is a top schematic view showing an illustrative liquid metal contact region having a pattern of concentric dots;
Figures 5A-5D are schematic side cross-sectional views showing an illustrative method of controlling the temperature of a microdevice using the thermal isolation structure of Figure 1; and
Figures 6A-6H are schematic side cross-sectional views showing an illustrative process of forming a passive analog thermal isolation structure.

The following description should be read with reference to the drawings, in which like elements in different drawings are numbered in like fashion. The drawings, which are not necessarily to scale, depict selected embodiments and are not intended to limit the scope of the invention. Although examples of construction, dimensions, and material are illustrated for the various elements, those skilled in the art will recognize that many of the examples provided have suitable alternatives that may be utilized.

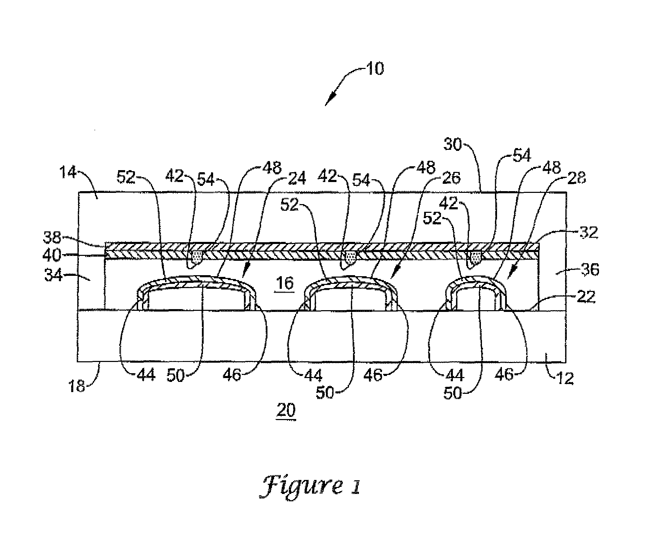

Figure 1 is a schematic side cross-sectional view showing an illustrative passive analog thermal isolation structure 10 in accordance with an exemplary embodiment of the present invention. As shown in Figure 1, the thermal isolation structure 10 can include a bottom substrate 12 and a top cap 14, which together define a sealed interior cavity 16 of the structure 10. The bottom substrate 12 can have a first side 18 that can be placed in intimate thermal contact with an external environment 20, and a second side 22 thereof that can be used to support a number of thermal bimorphs 24,26,28 adapted to deform between a first *(i.e.* undeformed) position and a second *(i.e.* deformed) position for transferring heat from the bottom substrate 12 to the top cap 14. The bottom substrate 12 can include, for example, a this wafer of silicon that can be fabricated in accordance with the steps discussed herein.

The top cap 14 can have a first side 30, a second side 32, and a number of side pillars 34,36 attached to the second side 22 of the bottom substrate 12. The top cap 14 can include a thin wafer of glass (*e.g.* Pyrex®), which can be fabricated using an etching or grinding process. The first side 30 of the top cap 14 can be used to attach the thermal isolation structure 10 to an adjacent structure such as the packaging of a MEMS device. The second side 32, in turn, can include several layers 38,40 of material, which as discussed herein, can be configured to support several optional liquid metal contact regions 42 that can be used to facilitate heat transfer from the thermal bimorphs 24,26,28 to the top cap 14 when brought into contact with each other. In certain embodiments, for example, the top cap 14 can include an inner layer 38 of tungsten or other thermally conductive material and an outer layer 40 of silicon nitride (SiN) film or other thermally isolative material. If desired, one or more intermediate layers (not shown) may be provided to facilitate bonding of the two layers 38,40 together,

The thermal isolation structure 10 can be hermetically sealed to prevent the inflow of gasses or other contaminants into the interior cavity 16. In some embodiments, the interior cavity 16 of the thermal isolation structure 10 can be vacuum-filled to prevent gasses or other undesired matter contained within the cavity 16 from interfering with the operation of the thermal bimorphs 24,26,28. The formation of a vacuum-filled interior cavity 16 can be accomplished, for example, by fabrication of the thermal isolation structure 10 in a clean room at vacuum pressures. Other techniques for vacuum-filling the interior cavity 16 can be utilized, however.

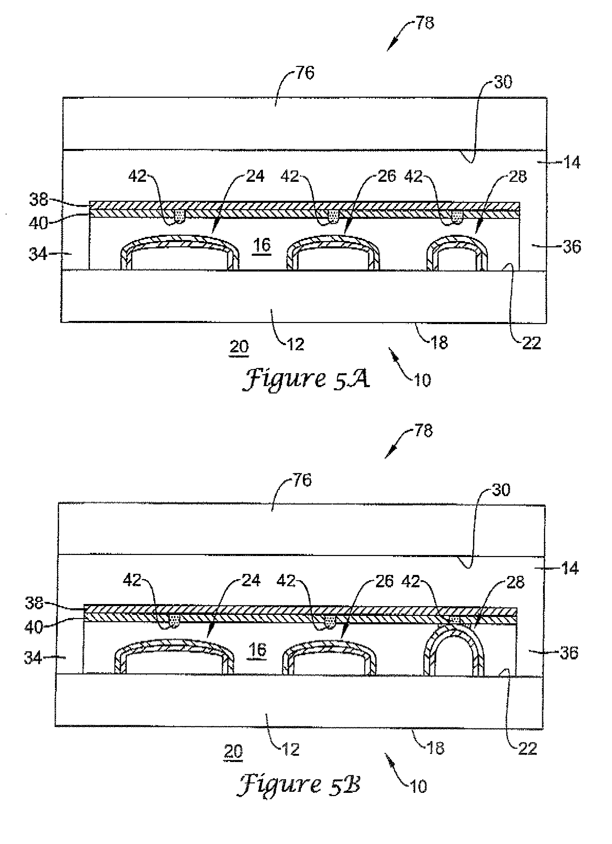

The thermal bimorphs 24,26,28 can each have a double-ended structure including a first end 44 and a second end 46, both of which can be formed over and attached to the second side 22 of the bottom substrate 12. In certain embodiments, for example, the thermal bimorphs 24,26,29 can each include a deformable beam with each end 44,46 fixed to the bottom substrate 12 by adhesion bending, thermal compression bonding, RF welding, ultrasonic welding, or other suitable technique. A contact surface 48 of each thermal bimorph 24,26,28 can overly the second side 22 of the bottom substrate 12, and can be configured to deform and make contact with the liquid metal contact regions 42 on the top cap 14, as further discussed below, for example, with respect to Figures 5A-5D,

While a double-ended thermal bimorph structure is depicted in the illustrative embodiment of Figure 1, it should be understood that the thermal bimorphs can have a single-ended structure in which the first end 44 is fixed to the substrate and the second end 46 is substantially free. In some embodiments, for example, the second (*i.e*. free) end 46 of each thermal bimorph 24,26,28 can be configured to freely overhang at least a portion of the bottom substrate 12, allowing the end 46 to deflect in response to changes in temperature. In use, a contact surface located at or near the second end 46 can be adapted to make contact with the top cap 14 to sink heat.

The thermal bimorphs 24,26,28 can each be fabricated from two or more layers of material having different thermal conductivity characteristics that permit the bimorphs 24,26,28 to rise and bow outwardly in response to temperature changes in the bottom substrate 12 as a result of temperature variations in the external environment 20. In certain embodiments, for example, the thermal bimorphs 24,2 6,28 can each include an inner layer 50 of material having a relatively high thermal conductivity coefficient (α), and an outer layer 52 of material having a relatively low thermal conductivity coefficient (α). In some embodiments, for example, the inner layer 50 may include a metal such as gold, which has a relatively high thermal conductivity coefficient of α = 14, whereas the outer layer 52 may include a metal such as tungsten, which has a relatively low thermal conductivity coefficient of α = 4.5. It should be understood, however, that other suitable thermally conductive material(s) can be used to fabricate the layers 50,52, if desired.

While only two layers 50,52 are shown in the illustrative embodiment of Figure 1, it should be understood that a greater or lesser number of layers could be used to form the thermal bimorphs 24,26,28, if desired. In one such embodiment, for example, the double ended thermal bimorphs 24,26,28 can be made substantially from a single material whose thermal expansion coefficient is different from the thermal expansion coefficient of the bottom substrate 12. In this case, when the bottom substrate 12 is heated, the double-ended thermal bimorph 24,26,28 can be configured to expand more than the bottom substrate 12, resulting in an induced stress that causes the bimorphs 24,26,28 to deform.

In use, as the thermal bimorphs 24,26,28 are heated by the bottom substrate 12, the difference in the thermal conductivity coefficients causes the layers 50,52 to expand at different rates, imparting a bias to the two materials that causes the thermal bimorphs 24,26,28 to rise in a direction towards the top cap 14. Conversely, as the temperature on the bottom substrate 12 decreases, the difference in thermal conductivity coefficients causes the layers 50,52 to contract at different rates, causing the thermal bimorphs 24,26,28 to move back to their initial *(i.e.* undeformed) positions, as shown, for example, in Figure 1.

The thermal bimorphs 24,26,28 can be configured such that one or more bimorphs 24,26,28 are adapted to deform and make thermal contact with the top cap 14 at different temperatures, allowing the thermal isolation structure 10 to passively sink more or less heat from the bottom substrate 12 depending on the temperature of the external environment 20 and/or the attached microdevice. In certain embodiments, for example, one or more of the thermal bimorphs 24,26,28 can have a different size and/or shape that causes the thermal bimorphs 24,26,28 to deform and make contact with the top cap 14 at different temperatures. A relatively small thermal bimorph 28, for example, can be configured to deform at a lower temperature than the remaining bimorphs 24,26, which based on their larger size, deform and make contact with the top cap 14 at higher temperatures. The thermal bimorphs 24,26,28 can be generally configured so that an increase in temperature in the external environment 20 causes an increase in the number of thermal bimorphs 24,26,28 that deform and make thermal contact with the top cap 14.

The thermal bimorphs 24,26,28 can be arranged in a pattern or array over the bottom substrate 12, providing a degree of symmetry to the thermal isolation structure 10 that permits heat to be transferred more uniformly from the bottom substrate 12 to the top cap 14. Typically, the thermal bimorphs 24,26,28 will be arranged in a two-dimensional pattern or array over the second side 22 of the bottom substrate 12. While only three thermal bimorphs 24,26,28 are depicted in cross-section in Figure 1 for sake of clarity, it should be understood that a greater or lesser number of thermal bimorphs can be formed above the bottom substrate 12, as desired.

The liquid metal contact regions 42 on the top cap 14 can each include a pattern or array of liquid metal droplets that overly the contact surfaces 48 of the thermal bimorphs 24,26,28. In the illustrative embodiment of Figure 1, the liquid metal contact regions 42 are shown formed within several trenches 54 of the second layer 40, which can be aligned with the contact surfaces 48 of the thermal bimorphs 24,26,28 to permit the liquid metal to wet and make thermal contact with the bimorphs 24,26,28 when brought together with the top cap 14. In some embodiments, the liquid metal contact regions 42 can include a liquid gallium material. Gallium is considered a particularly useful material based on its relatively low melting point (*i.e.* < 30°C), and since it is able to undergo substantial heating at relatively low levels of evaporation. It should be understood, however, that other liquid metals could be utilized, if desired.

The inner layer 38 of the top cap 14 can include a metal that wets well to the liquid metal disposed within the trenches 54. In one such embodiment, for example, the inner layer 38 can be formed from a tungsten or platinum material, which wets well with liquid gallium, The affinity of the inner layer 38 material to wet well with the liquid metal ensures that the liquid metal remains in constant contact with the inner layer 38 as the thermal bimorphs 24,26,28 rise and come into contact with the top cap 14. In contrast to the inner layer 38, the outer layer 40 of the top cap 14 can include a relatively non-wettable material such as silicon nitride (SiN) or silicon dioxide (SiO₂), which resists wetting with liquid metals such as liquid gallium. In use, the combination of wettable and non-wettable materials used to form the inner and outer layers 38,40 causes the liquid metal to remain within the trenches 54 as each thermal bimorph 24,26,28 rises and makes contact with the top cap 14, and, subsequently, as each bimorph 24,2628 falls and detaches from the top cap 14.

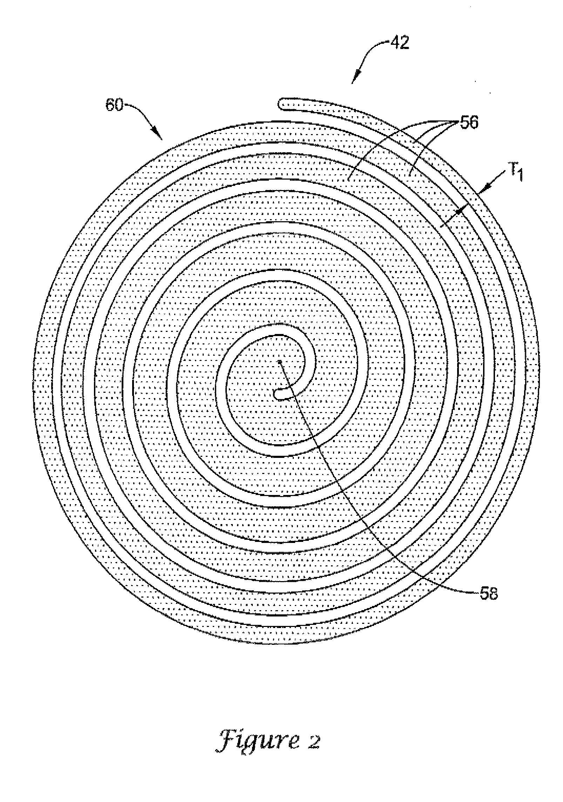

Figure 2 is a top schematic view showing an illustrative liquid metal contact region 42 having a spiraled pattern. As shown in Figure 2, each liquid metal contact region 42 can include a number of liquid metal spirals 56 forming a center section 58 and an outer periphery 60 of the contact region 42. Formation of the spirals 58 can be accomplished, for example, by forming spiral-shaped trenches 54 within the outer layer 40 of the top cap 14 in Figure 1, leaving intact the inner layer 38 of wettable material. In certain embodiments, and as further shown in Figure 2, the thickness T₁ of the spirals 56 may decrease from the center section 58 of the contact region 42 towards the outer periphery 60 thereof so that a greater amount of liquid metal is wetted towards the center section 58. In use, the varying thickness T₁ of the spirals 56 helps to encourage the liquid metal to migrate towards the center section 58 of the contact region 42 in order to prevent the ejection of liquid metal beyond the outer periphery 60.

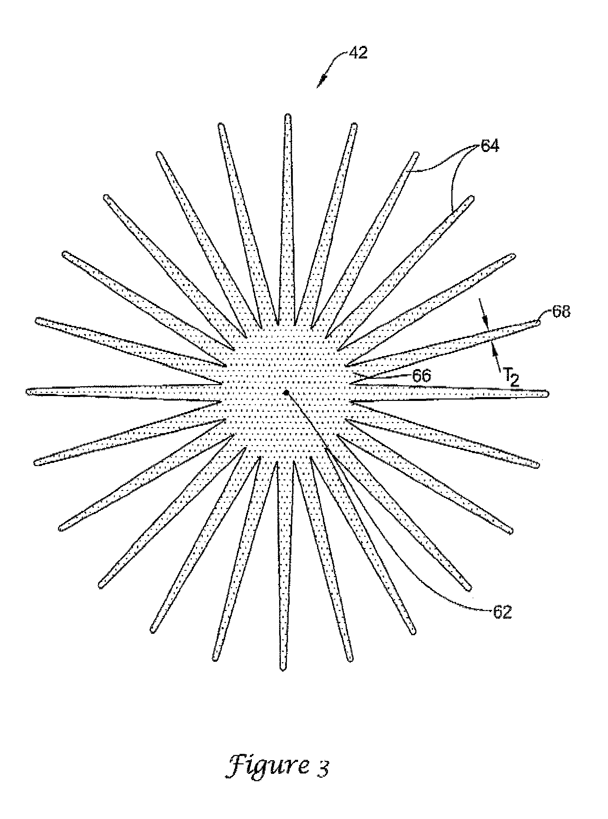

Figure 3 is a top schematic view showing an illustrative liquid metal contact region 42 having a star-shaped pattern. As shown in Figure 3, each liquid metal contact region 42 can have a star-shaped configuration including a center section 62 and a number of fingers 64 extending radially away from the center section 62. The radially extending fingers 64 can each have a tapered configuration with the thickness T₂ along the length of each finger 64 decreasing in size from an inner portion 66 of each finger 64 to an outer portion 68 thereof. In use, the varying thickness T₂ along the length of each finger 64 helps to encourage the liquid metal to migrate towards the center section 62 of the contact region 42.

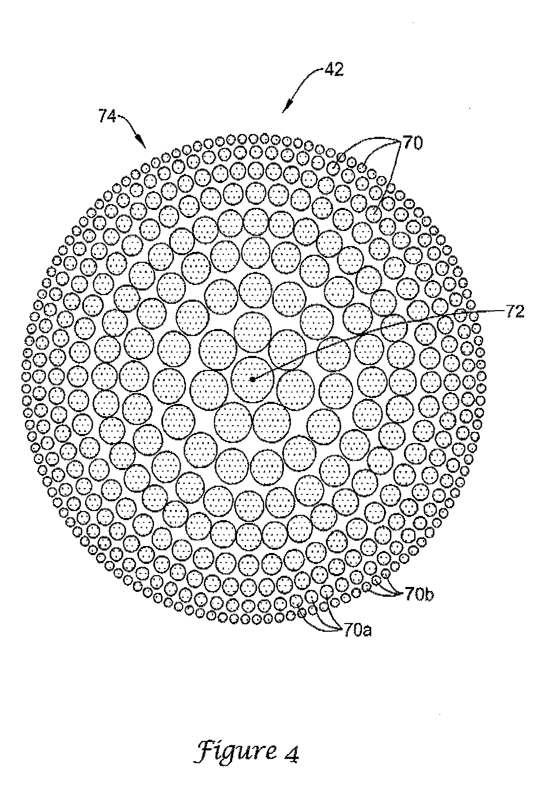

Figure 4 is a top schematic view showing an illustrative liquid metal contact region having a pattern of concentric dots. As shown in Figure 4, each liquid metal contact region 42 can include a number of individual liquid metal dots 70 arranged in concentric rings extending radially from a center section 72 of the contact region 42 to an outer periphery 74 thereof. The diameter of the dots 70 can generally decrease in size 6-om the center section 72 of the contact region 42 towards the outer periphery 74, with the diameter of those individual dots 70 within each concentric ring of dots 70 being substantially the same. As shown in Figure 4, for example, a first number of dots 70a located closer to the center section 72 of the contact region 42 can each have the same diameter, and are generally larger than the diameter of each dot 70b within the next concentric ring located further towards the outer periphery 74. In use, the decreasing diameter of each of the dots 70 from the center section 72 to the outer periphery 74 helps to encourage the liquid metal to migrate towards the center section 72.

Referring now to Figures 5A-5D, an illustrative method of passively controlling the temperature of a microdevice using the illustrative thermal isolation structure 10 of Figure 1 will now be described. As shown in a first view in Figure 5A, the top cap 14 of the thermal isolation structure 10 can be attached to the wafer 76 of a microdevice 78 in which passive and analog temperature regulation is desired. The microdevice 78 may comprise, for example, an inertial sensor, switch, relay, actuator, optical lens, valve or other such component in which a fixed operating temperature is desired. In a MEMS-based inertial sensor, for example, where it is often desired to maintain the sensor components at a fixed temperature *(e.g.* +55°C), the thermal isolation structure 10 can be configured to function as an interposer thermal switch package, providing a passive and analog thermal interface that allows the attached device 78 to operate without the need for active heating elements.

At an initial low-temperature position illustrated generally in Figure 5A, none of the thermal bimorphs 24,26,28 are deformed towards the top cap 14 of the thermal isolation structure 10. Such initial position may represent, for example, the thermal response of the thermal isolation structure 10 to a temperature at or near the bottom range of the operating temperature spectrum *(e.g.* 40°C) of the device 78. In this position, the thermal bimorphs 24,26,28 can be configured to remain in their initial, non-deformed position, thus making no contact with the liquid metal contact regions 42 on the top cap 14.

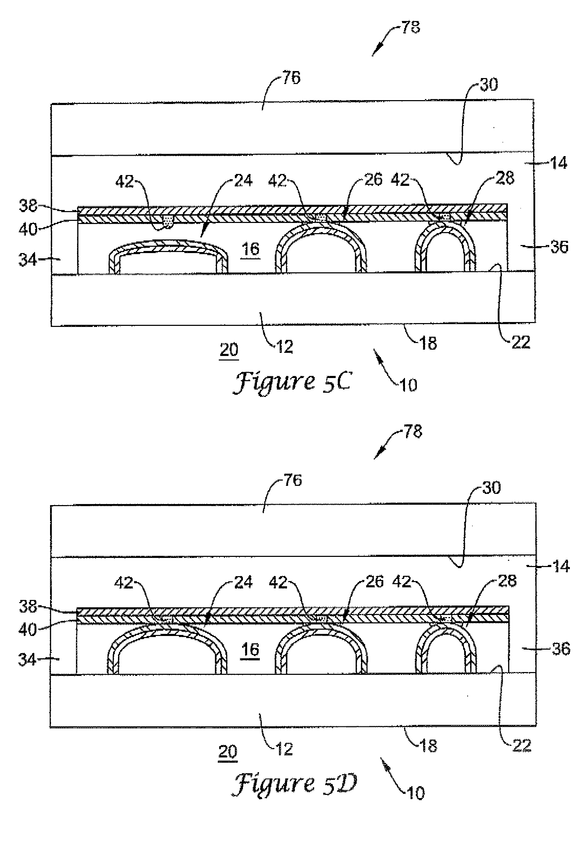

Figures 5B-5D are schematic views showing the thermal isolation structure 10 in response to an increase in temperature within the external environment 20. As the temperature within the external environment 20 increases, increasing numbers of thermal bimorphs 24,26,28 can be configured to successively rise and make thermal contact with the liquid metal contact regions 42 on the top cap 14, creating thermal shorts that sink more heat away from the bottom substrate 12 and to the top cap 14. As shown in a second view in Figure 5B, for example, the presence of additional heat within the external environment 20 causes a relatively small thermal bimorph 28 to initially deform and make contact with a corresponding liquid metal contact region 42 on the top cap 14. Further increases in temperature within the external environment 20 cause the larger thermal bimorphs 26,24 to each successively deform and make contact with the liquid metal contact regions 42, as further shown, for example, in Figures 5C and 5D.

The attached device 78 can be configured to self-heat using the heat transferred from the top cap 14 to the wafer 76, allowing the microdevice 78 to operate at a constant temperature or within a particular temperature range irrespective of the ambient temperature within the external environment 20. In certain applications, for example, the thermal isolation structure 10 can be configured to maintain the wafer 76 at a temperature of about +55°C irrespective of the ambient temperature within the external environment 20. Because the thermal bimorphs 24,26,28 are configured to passively heat the device 78 without the need for active heating elements, a lower amount of power is required to maintain the wafer 76 at a desired temperature range. In some cases, the device 78 may be able to self-heat using only the onboard power needed to operate the device 78. By optionally using liquid metal contact regions 42 including a liquid metal material such as liquid gallium, a more robust, reliable thermal contact can be achieved as the thermal bimorphs 24,26,28 rise and make thermal contact with the top cap 14.

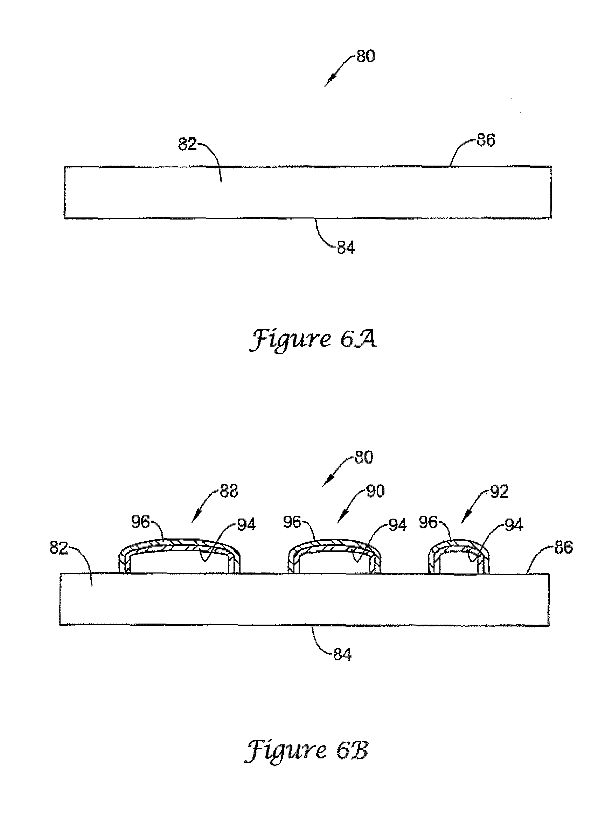

Referring now to Figures 6A-6H, an illustrative process of forming a thermal isolation structure similar to the illustrative structure 10 of Figure 1 will now be described. The process, represented generally by reference number 80, may begin in Figure 6A with the step of providing a bottom substrate 82 having a first side 84 and a second side 86, Substrate 82 may include, for example, a thin wafer of silicon, gallium, arsenide, germanium, glass, or other suitable wafer material.

Figure 6B is a schematic side cross-sectional view showing the formation of a pattern or array of thermal bimorphs 88,90,92 over the second side 86 of the bottom substrate 82. As shown in Figure 6B, the thermal bimorphs 88,90,92 can each be fabricated by micromachining a first layer 94 of material over the bottom substrate 82 having a relatively high thermal conductivity coefficient followed by a second layer 96 of material having a relatively low thermal conductivity coefficient. To further bimorph the two layers 94,96, the first layer 94 can be applied under compression whereas the second layer 96 is applied under tension, thus imparting a residual stress within the thermal bimorphs 88,90,92 that further causes them to bow outwardly when heated. Typically, the second layer 96 of material will include a wettable material, which facilitates wetting of the thermal bimorphs 88,90,92 to the liquid metal contact regions, as discussed herein. In certain embodiments, for example, the first layer 94 may include a metal such as gold whereas the second layer 96 may include a wettable metal such as tungsten or platinum. The selection of materials used in fabricating the thermal bimorphs 88,90,92 may vary, however, to impart a particular thermal characteristic to the thermal isolation structure, as desired.

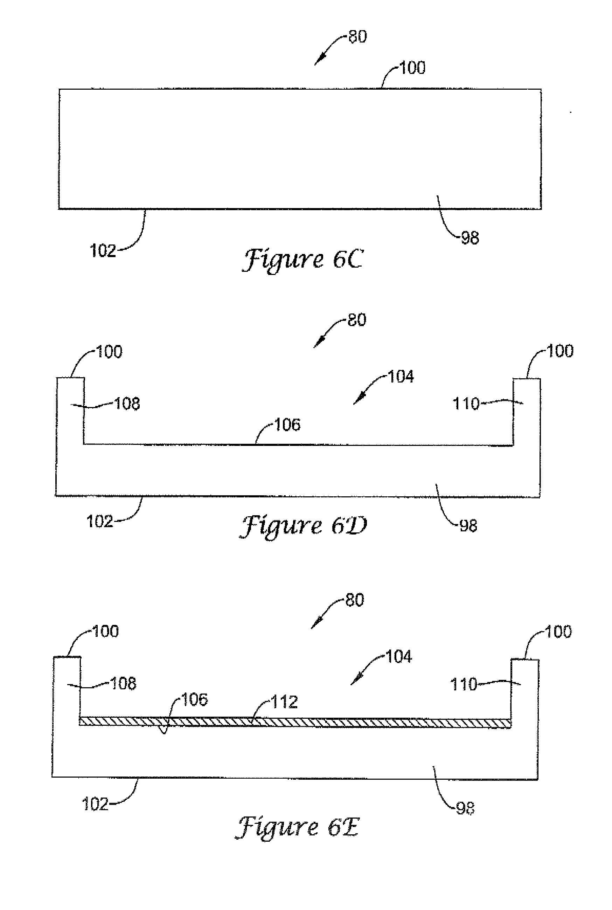

Figures 6C-6G are schematic side cross-sectional views showing several illustrative steps of forming a top cap of the thermal isolation structure. As shown in Figure 6C, formation of the top cap can begin by providing a top cap substrate 98 having a first side 100 and a second side 102. The substrate 98 may include, for example, a thin wafer of glass such as Pyrex®. Other materials such as silicon, gallium, arsenide, germanium, etc. could also be used, if desired.

Figure 6D is a schematic side cross-sectional view showing the formation of a trench 104 within the first side 100 of the substrate 98 of Figure 6C. As can be seen in Figure 6D, the formation of the trench 104 within the substrate 98 creates an indented surface 106 and a number of side pillars 108,110 that can be later used to attach the substrate 98 to the bottom substrate 82 depicted in Figure 6B. Formation of the trench 104 can be accomplished, for example, using a wet or dry etching technique known in the art.

Figures 6E-6F are schematic side cross-sectional views showing the formation of several layers 112,114 over the indented surface 106 of the substrate 98, similar to the layers 38,40 described above with respect to Figure 1, As shown in Figure 6E, a first layer 112 of wettable metal such as tungsten or platinum can be first formed over the indented surface 106. In certain embodiments, for example, the first layer 112 can be formed by sputtering metallic particles onto the indented surface 106 using a suitable sputtering process such as laser sputtering. Other techniques such as vapor deposition or adhesion could also be utilized, if desired.

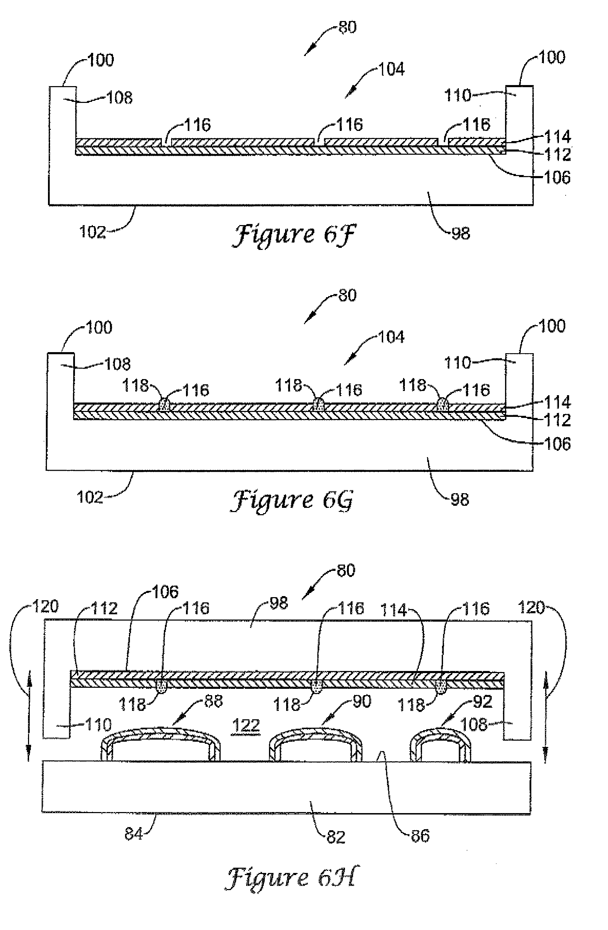

As can be further seen in Figure 6F, a second layer 114 of non-wettable material such as silicon nitride (SiN) can then be formed over the first layer 112, which can be processed to form a pattern or array of trenches 116 for receiving the liquid metal of the liquid metal contact regions, as discussed herein. In certain embodiments, for example, formation of the trenches 116 can be accomplished using a patterned photomask and a suitable etchant configured to selectively etch the second layer 114 material. In certain techniques, for example, a Deep Reactive Ion Etching (DRIE) can be used to selectively etch the second layer 114 material. Other fabrication techniques for forming the tenches 116 could also be utilized, if desired.

Figure 6G is a schematic side cross-sectional view showing the deposition of the liquid metal 118 into the trenches 116 shown in Figure 6F. As shown in Figure 6G, the affinity of the liquid metal 118 to wet with the first layer 112 material acts to hold the liquid metal 118 within the trenches 116.

Figure 6H is a schematic side cross-sectional view showing an illustrative step of attaching the bottom substrate 82 of Figure 6B to the top cap substrate 98 of Figure 6G. As indicated generally by arrow 120 in Figure 6H, the top cap substrate 98 can be flipped over and then attached to the bottom substrate 82 using each of the side pillars 108,110. Bonding of the two substrates 82,98 together can be accomplished using any number of suitable bonding techniques, including, for example, anodic bonding, adhesion bonding, thermal compression bonding, RF welding, ultrasonic welding, etc. In certain embodiments, such bonding process can be performed under vacuum pressure such that the interior cavity 122 formed by the bonded structure is relatively free of any impurities that can affect the performance of the structure. If desired, additional elements such as getter dots can be provided within the interior cavity 122 to chemically sorb any contaminants that can result from the outgassing of common atmospheric gasses and packing-material vapors during processing, and/or by the diffusion or microleaking of such materials into the interior cavity 122 over time.

Having thus described the several embodiments of the present invention, those of skill in the art will readily appreciate that other embodiments may be made and used which fall within the scope of the claims attached hereto. Numerous advantages of the invention covered by this document have been set forth in the foregoing description. It will be understood that this disclosure is, in many respects, only illustrative. Changes can be made with respect to various elements described herein without exceeding the scope of the invention.

## Claims

1. A thermal isolation structure (10), **characterized by**:
a substrate wafer (12) and a cap wafer (14) defining an interior cavity (16);
a plurality of thermal bimorphs (24,26,28) each coupled to the substrate wafer (12) and thermally actuatable between a first position and a second position, each thermal bimorph (24,26,28) including a first end (44), a second end (46), and a contact surface (48) adapted to make contact with the cap wafer (14) in said second position; and
wherein one or more of the thermal bimorphs (24,26,28) are adapted to passively deform and make contact with the cap wafer (24,26,28) at different temperatures.

2. The thermal isolation structure of claim 1, wherein each thermal bimorph (24,26,28) includes a double-ended structure.

3. The thermal isolation structure of claim 2, wherein the first and second ends (44,46) of each thermal bimorph (24,26,28) are attached to the substrate wafer (12).

4. The thermal isolation structure of claim 1, wherein each thermal bimorph (24,26,28) includes a single-ended structure.

5. The thermal isolation structure of claim 1, further **characterized by**:
at least one layer of wettable material (38,40) coupled to the cap wafer (14); and
a pattern of liquid metal contact regions (42) including a liquid metal adapted to wet with said at least one layer of wettable material (38,40).

6. The thermal isolation structure of claim 5, wherein said pattern of liquid metal contact regions (42) is a spiraled pattern.

7. The thermal isolation structure of claim 5, wherein said pattern of liquid metal contact regions (42) is a star-shaped pattern.

8. The thermal isolation structure of claim 5, wherein said pattern of liquid metal contact regions (42) is a pattern of concentric dots (70).

9. The thermal isolation structure of claim 1, wherein each thermal bimorph (24,26,28) includes a first layer of material (50) having a first temperature conductivity coefficient, and a second layer of material (52) having a second temperature conductivity coefficient different than said first temperature conductivity coefficient.

10. The thermal isolation structure of claim 1, wherein each thermal bimorph (24, 26, 28) has a temperature coefficient greater than a temperature coefficient of the substrate wafer (12).
